**Europäisches Patentamt**

**European Patent Office**

**Office européen des brevets**

(19)

(11) Veröffentlichungsnummer: **0 283 874 B1**

(12) # EUROPÄISCHE PATENTSCHRIFT

(45) Veröffentlichungstag der Patentschrift:
10.04.91 Patentblatt 91/15

(51) Int. Cl.⁵: **C23C 16/44, C30B 25/14**

(21) Anmeldenummer: **88103857.4**

(22) Anmeldetag: **11.03.88**

(54) **Vorrichtung zur Erzeugung eines Gasgemisches nach dem Sättigungsverfahren.**

(30) Priorität: **19.03.87 DE 3708967**

(43) Veröffentlichungstag der Anmeldung:
**28.09.88 Patentblatt 88/39**

(45) Bekanntmachung des Hinweises auf die
Patenterteilung:
**10.04.91 Patentblatt 91/15**

(84) Benannte Vertragsstaaten:
**DE FR GB IT NL**

(56) Entgegenhaltungen:
**EP-A- 0 151 200
WO-A-86/01232
DE-A- 3 044 892**

(73) Patentinhaber: **MERCK PATENT
GESELLSCHAFT MIT BESCHRÄNKTER
HAFTUNG
Frankfurter Strasse 250 Postfach 4119
W-6100 Darmstadt (DE)**

(72) Erfinder: **Sielaff, Günter, Dr.
Schelmengasse 24
W-6140 Bensheim 6 (DE)**
Erfinder: **Joseph, Frank, Dipl.- Ing.
Breslauer Strasse 11a
W-6084 Gernsheim (DE)**
Erfinder: **Harder, Norbert, Dr.
Steingasse 15a
W-8759 Aschaffenburg (DE)**

## Beschreibung

Die Erfindung betrifft eine Vorrichtung zur Erzeugung eines Gasgemisches nach dem Sättigungsverfahren, mit einem Vor ratsbehälter für die Flüssigkeit und mit einem Tauchrohr zur Einleitung eines Trägergases in die Flüssigkeit.

Derartige Vorrichtungen dienen dazu, einen kontinuierlichen Volumenstrom eines definierten Gemisches aus einem Trägergas und einer Beimengung zu erzeugen. Das hierbei angewandte Sättigungsverfahren (VDI-Richtlinie 3490, Bl. 13) besteht darin, daß das Trägermaterial durch die auf einer bestimmten Temperatur gehaltene FLüssigkeit (kondensierte Phase oder Beimengung) geleitet und dabei gesättigt wird. Der Volumengehalt der Beimengung wird durch den Partialdruck der Beimengung bestimmt, bezogen auf den Gesamtdruck des Gasgemisches bei der jeweiligen Temperatur.

Diese Vorrichtungen werden insbesondere als Quellen für Stoffe für spezielle Prozesse der Halbleiterfertigung eingesetzt, wie beispielsweise für CVD-, Dotier- und Diffusionsprozesse, daneben aber auch für Abscheidungsprozesse zur Herstellung von optischen Fasern.

Die besonderen Schwierigkeiten dieser Verfahren liegen vor allem darin, eine genau gleichbleibende Konzentration der Beimengung im Gasgemisch einzuhalten. Bei der Herstellung von optischen Gradientenfasern ist es sogar erforderlich, ein genau vorgegebenes Konzentrationsprofil zu fahren.

Allen bekannten Vorrichtungen der eingangs genannten Gattung ist gemeinsam, daß die Sättigung des Trägergases in dem die Flüssigkeit enthaltenden Vorratsbehälter erfolgt. Das Trägergas wird durch ein Tauchrohr in die Flüssigkeit eingeleitet und perlt nach oben, wobei es mit der Beimengung aus der Flüssigkeitsphase gesättigt wird. Der erzielte Sättigungsgrad hängt von der Länge des Weges ab, den die Gasblasen durch die Flüssigkeit zurücklegen, und ändert sich deshalb, wenn der Füllstand im Vorratsbehälter abnimmt. So kommt es z.B. bei den in EP 0,151,200 und WO 86/01232 beschriebenen Vorrichtungen zu einer beträchtlichen Änderung des Füllstands des Vorratsgefäßes und damit zu erheblichen Schwankungen der Länge der Gasbeladungsstrecke.

Um Temperatureinflüsse auszuschließen, muß der gesamte Vorratsbehälter durch eine Temperaturregeleinrichtung auf der gewünschten Temperatur gehalten werden. Wird der auch als Vorlage bezeichnete Vorratsbehälter z.B. gegen einen anderen ausgetauscht oder z.B. nach weitgehender Entleerung neu befüllt, ist die Vorrichtung erst nach längerer Zeit wieder betriebsbereit, wenn der gesamte Flüssigkeitsvorat die vorgegebene Temperatur erreicht hat. Eine gewünschte liderung der Flüssigkeitstemperatur kann bei einer derartigen Vorrichtung üblicherweise erst nach mehreren Stunden eingestellt werden. Auch die in EP 0,151,200 und WO 86/01232 beschriebenen Vorrichtungen weisen ein unzureichendes Temperaturregelverhalten auf, da die nachzufüllende Flüssigkeit nicht temperiert wird und die Heizvorrichtungen für das Vorratsgefäß, soweit vorgesehen, nicht ausreichend dimensioniert sind.

Diese bekannten Vorrichtungen zur Erzeugung eines Gasgemisches nach dem Sättigungsverfahren werden wegen der aus dem Tauchrohr oder Frittenrohr aufsteigenden Gasblasen auch als "Bubbler" bezeichnet; der Volumenstrom wird durch eine Regelung des Massenflusses des Trägergases geregelt.

Aufgabe der Erfindung ist es, eine Vorrichtung der eingangs genannten Gattung zu schaffen, die unter allen Betriebsbedingungen eine genaue Konstanthaltung der beigemengten Stoffmenge und damit des Sättigungsgrades des erzeugten Gasgemisches ermöglicht und mit der auch eine verhältnismäßig rasche und gesteuerte Konzentrationsänderung erreicht werden kann.

Diese Aufgabe wird erfindungsgemäß dadurch gelöst, daß der Vorratsbehälter über eine Flüssigkeitsleitung mit einem gesonderten Reaktionsgefäß verbunden ist, dem das Trägergas über das Tauchrohr zugeführt wird, wobei das Volumen des Reaktionsgefäßes wesentlich geringer als das Volumen des Vorratsbehälters ist, wobei das Reaktionsgefäß einen berührungslosen Füllstandsgeber aufweist, der eine Mengendosiereinrichtung in der zum Reaktionsgefäß führenden Flüssigkeitsleitung steuert, und wobei weiter das Reaktionsgefäß in einem mit einer Temperaturregeleinrichtung verbundenen Metallblock angeordnet ist.

Im Gegensatz zu den bekannten Vorrichtungen erfolgt gemäß der Erfindung die Trägergassättigung in einem gesonderten Reaktionsgefäß und nicht in dem Vorratsbehälter. Das Reaktionsgefäß kann deshalb ein wesentlich geringeres Volumen als der Vorratsbehälter aufweisen, so daß ein erheblich besseres regelungstechnisches Zeitverhalten erreicht wird. Auch nach einem Auswechseln des Vorratsbehälters bleibt das Reaktionsgefäß aus seiner vorgegebenen Betriebstemperatur und ist deshalb sofort betriebsbereit. Das geringe Volumen des Reaktionsgefäßes ermöglicht eine rasche Temperaturänderung, wenn diese beispielsweise zur Erzeugung eines Konzentrations-Gradienten erforderlich ist. Diese Temperaturänderung des Reaktionsgefäßes wird innerhalb von wenigen Minuten erreicht, während bei bekannten Vorrichtungen hierfür mehrere Stunden erforderlich waren.

Die in dem Vorratsbehälter vorhandene Flüssigkeitsmenge kann ohne Beeinträchtigung des Sättigungsvorgangs, der im gesonderten Reaktionsgefäß erfolgt, bis zu einem sehr kleinen Rest ausgeschöpft werden. Im Vergleich dazu mußte bei herkömmlichen Vorrichtungen ein Rest von etwa 20% der ursprünglichen Flüssigkeitsmenge im Bubbler-Behälter verbleiben, da anderenfalls keine ausreichende Sättigung des aus dem Tauchrohr austretenden Trägergases erreicht werden konnte.

Da der Flüssigkeitsstand im gesonderten Reaktionsgefäß unabhängig von der jeweils im Vorratsbehälter vorhandenen Flüssigkeitsmenge durch den Füllstandsgeber und die Mengendosiereinrichtung konstant gehalten wird, kann auch die Trägergassättigung und damit – bei massenflußgeregeltem Trägergasstrom – der Volumengehalt der Beimengung im Trägergas mit hoher Genauigkeit konstant gehalten werden. Dies ist beispielsweise von besonderer Bedeutung, wem es sich bei der Beimengung um einen Dotierstoff für einen Dotiervorgang in der Halbleiterfertigung handelt.

Um die Möglichkeit einer Kontamination der Beimengung, beispielsweise eines Dotierstoffes, durch eine chemische Reaktion der Gefäßwand mit Hydrolyseprodukten, die durch Wasserspuren im Trägergas verursacht werden, auszuschließen, genügt es, das Reaktionsgefäß aus Quarz herzustellen ; dagegen kann der Vorratsbehälter aus Glas bestehen, da im Vorratsbehälter kein Trägergas durch die Flüssigkeit strömt. Es ist nicht erforderlich, am Vorratsbehälter eine Temperaturmeßtasche vorzusehen, bei der eine Bruchgefahr nicht ausreichend ausgeschlossen werden kann.

Der Vorratsbehälter wird praktisch drucklos betrieben, so daß eine erhöhte Arbeitssicherheit gewährleistet ist. Das Glasgefäß des Vorratsbehälter kann kunststoffummantelt sein, da keine Temperierung des Vorratsbehälters nötig ist. Auf diese Weise wird erreicht, daß sogar bei einem Glasbruch das Austreten von aggressiver Flüssigkeit verhindert wird.

Das Reaktionsgefäß besteht vorzugsweise aus Quarz. Um die vom nichttemperierten Vorratsbehälter kommende Flüssigkeitsmenge auf die eingestellte Temperatur des Reaktionsgefäßes zu bringen, wird die Flüssigkeitsleitung vorzugsweise durch eine oder mehrere Bohrungen im Metallblock zum Reaktionsgefäß geführt.

Weitere vorteilhafte Ausgestaltungen des Erfindungsgedankens sind Gegenstand weiterer Unteransprüche.

Die Erfindung wird nachfolgend an Ausführungsbeispielen näher erläutert, die in der Zeichnung dargestellt sind. Es zeigt :

Fig. 1 in stark vereinfachter Darstellungsweise eine Vor richtung zur Erzeugung eines Gasgemisches nach dem Sättigungsverfahren mit einem Vorratsbehälter und einem gesonderten Reaktionsgefäß und

Fig. 2 ein gegenüber der Ausführung nach Fig. 1 abgewandeltes Reaktionsgefäß ebenfalls in vereinfachter Darstellungsweise im senkrechten Schnitt.

Ein Trägergas, beispielsweise Stickstoff, wird durch eine Gaszuleitung 1 einem Vorratsbehälter 2 zugeführt. Der Vorratsbehälter 2 besteht aus Glas und enthält eine Flüssigkeit 3, die in gasförmiger Phase dem Trägergas beigemengt werden soll. Das Trägergas beaufschlagt den über der Flüssigkeit befindlichen Raum des Vorratsbehälters 2 und drückt die Flüssigkeit durch eine Steigleitung 4 in eine Flüssigkeitsleitung 5, die zu einem Reaktionsgefäß 6 führt.

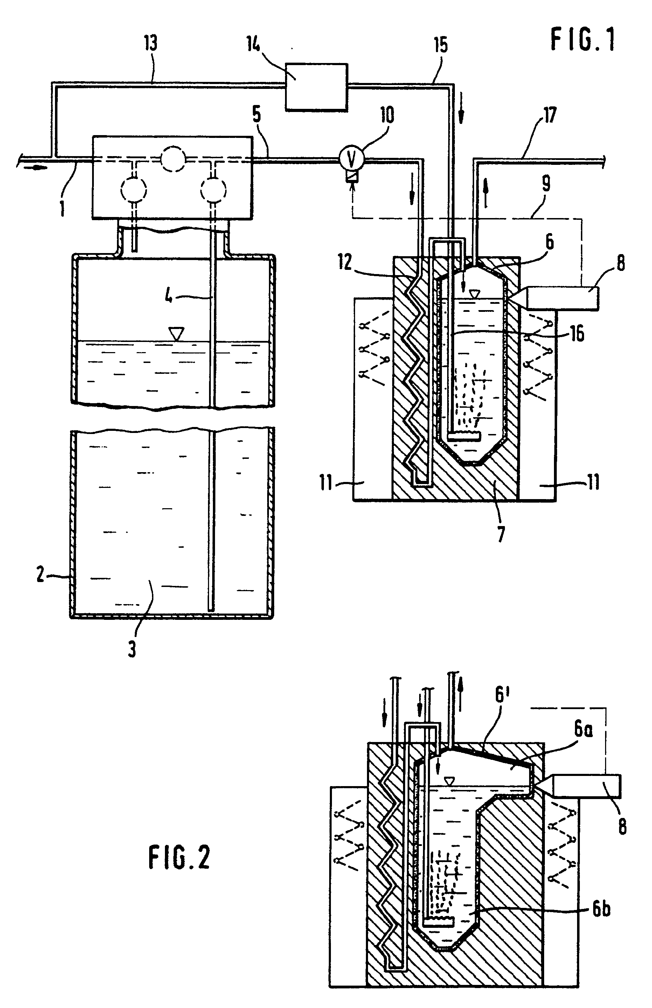

Das Reaktionsgefäß 6 besteht aus Quarz und ist von einem Metallblock 7 umgeben. Am Reaktionsgefäß 6 ist ein berührungsloser Füllstandsgeber 8 angeordnet, beispielsweise eine Lichtschranke oder ein kapazitiver Initiator, der über eine in Fig. 1 mit getrichelter Linie dargestellte Steuer leitung 9 mit einem Ventil 10 als Stellglied in der Flüssigkeitsleitung 5 verbunden ist. Der Füllstandsgeber 8 bildet mit dem Ventil 10 einen einfachen Zweipunktregler, der dazu dient, im Reaktionsgefäß 6 einen vorgegebenen Füllstand aufrechtzuerhalten. Anstelle der dargestellten Ausführung kann das Ventil 10 auch in der zum Vorratsbehälter 2 führenden Trägergasleitung 1 angeordnet sein.

Zur Konstanthaltung bzw. gezielten Beeinflussung der Temperatur des Reaktionsgefäßes 6 ist eine Temperaturregeleinrichtung vorgesehen, die bei dem dargestellten Ausführungsbeispiel Peltierelemente 11 an der Außnseite des Metallblocks 7 aufweist.

Um die aus dem Vorratsbehälter 2 dem Reaktionsgefäß 6 zugeführte Flüssigkeit auf die gewünschte Temperatur zu bringen, ist vorgesehen, daß die Flüssigkeitsleitung 5 an eine oder mehrere in der Zeichnung nur schematisch dargestellte Bohrungen 12 im Metallblock 7 angeschlossen ist, die mit dem Zulauf zum Reaktionsgefäß 6 verbunden ist bzw. sind.

Durch eine von der Trägergasleitung 1 abgezweigte Gasleitung 13 wird ein vorgegebener Volumenstrom von Trägergas über eine in Fig. 1 nur angedeutete Volumenstrom-Regeleinrichtung 14, beispielsweise einen thermischen Massenflußregler, und eine Leitung 15 einem Tauchrohr oder Frittenrohr 16 zugeführt, das im unteren Bereich des Reaktionsgefäßes 6 mündet. Von dort steigen die Blasen des Trägergases durch die im Reaktionsgefäß 6 enthaltene Flüssigkeitsmenge auf und werden dabei gesättigt. Durch eine Gemischleitung 17 tritt das Gasgemisch aus dem Reaktionsgefäß 6 aus.

Das Volumen des Reaktionsgefäßes 6 wird so klein wie möglich gewählt ; es nimmt aber mindestens das 1,5- bis 2-fache des Flüssigkeitsvolumens auf, das für jeweils eine einzelne Prozeßcharge benötigt wird. Beispielsweise beträgt das Volumen des Reaktionsgefäßes 10-20 ml.

Das Verhältnis der Höhe zum Durchmesser des Reaktionsgefäßes 6 liegt angenähert im Bereich 4 : 1 bis 8 : 1.

Die in Fig. 2 gezeigte Ausführungsform des Reaktionsgefäßes 6' unterscheidet sich von der Ausführungsform nach Fig. 1 nur dadurch, daß das Reaktionsgefäß 6' in seinem oberen Teil 6a im Bereich des Füllstandsgebers 8 mit wesentlich größerem Durchmesser ausgeführt ist als in seinem unteren Teil 6b. Dadurch wird erreicht, daß die auftretenden Füllstandsänderungen bei Änderungen des Flüssigkeitsvolumens im Reaktionsgefäß 6' nur sehr gering sind.

## Ansprüche

1. Vorrichtung zur Erzeugung eines Gasgemisches nach dem Sättigungsverfahren, mit einem Vorratsbehälter für die Flüssigkeit und mit einem Tauchrohr zur Einleitung eines Trägergases in die Flüssigkeit, wobei der Vorratsbehälter (2) über eine Flüssigkeitsleitung (5) mit einem gesonderten Reaktionsgefäß (6) verbunden ist, dem das Trägergas über das Tauchrohr (16) zugeführt wird, dadurch gekennzeichnet, daß das Volumen des Reaktionsgefäßes (6) wesentlich geringer als das Volumen des Vorratsbehälters (2) ist, daß das Reaktionsgefäß (6) einen berührungslosen Füllstandsgeber (8) aufweist, der eine Mengendosiereinrichtung (10) in der zum Reaktionsgefäß (6) führenden Flüssigkeitsleitung (5) steuert, und daß das Reaktionsgefäß (6) in einem mit einer Temperaturregeleinrichtung (11) verbundenen Metallblock (7) angeordnet ist.

2. Vorrichtung nach Anspruch 1, dadurch gekennzeichnet, daß das Reaktionsgefäß (6) aus Quarz besteht.

3. Vorrichtung nach Anspruch 1, dadurch gekennzeichnet, daß die von der Mengendosiereinrichtung (10) kommende Flüssigkeitsleitung (5) durch eine oder mehrere Bohrungen (12) im Metallblock (7) zum Tauchrohr (16) geführt ist.

4. Vorrichtung nach Anspruch 1, dadurch gekennzeichnet, daß das Verhältnis der Höhe zum Durchmesser des Reaktionsgefäßes (6) angenähert im Bereich von 4 : 1 bis 8 : 1 liegt.

5. Vorrichtung nach Anspruch 1, dadurch gekennzeichnet, daß die Mengendosiereinrichtung als Zweipunktregler mit einem zwischen einer geschlossenen und einer geöffneten Stellung umschaltbaren Ventil (10) in der Flüssigkeitsleitung (5) ausgeführt ist.

6. Vorrichtung nach Anspruch 1, dadurch gekennzeichnet, daß das Reaktionsgefäß (6') in seinem oberen Teil (6a) im Bereich des Füllstandsgebers (8) mit wesentlich größerem Durchmesser ausgeführt ist als in seinem unteren Teil (6b).

## Claims

1. Device for producing a gas mixture by the saturation method, having a stock vessel for the liquid and a dip tube for introducing a carrier gas into the liquid, the stock vessel (2) being connected via a liquid line (5) to a separate reaction vessel (6), to which the carrier gas is fed via the dip tube (16), characterised in that the volume of the reaction vessel (6) is substantially smaller than the volume of the stock vessel (2), that the reaction vessel (6) has a contactless level sensor (8) which controls a flow regulation instrument (10) in the liquid line (5) leading to the reaction vessel (6), and that the reaction vessel (6) is disposed in a metal block (7) connected to a temperature control system (11).

2. Device according to Claim 1, characterised in that the reaction vessel (6) consists of quartz.

3. Device according to Claim 1, characterised in that the liquid line (5) coming from the flow regulation instrument (10) passes through one or more holes (12) in the metal block (7) to the dip tube (16).

4. Device according to Claim 1, characterised in that the height/diameter ratio of the reaction vessel (6) is approximately in the range from 4 : 1 to 8 : 1.

5. Device according to Claim 1, characterised in that the flow regulation instrument in the liquid line (5) is designed as a two-point controller having a valve (10) which can be changed over between a closed position and an open position.

6. Device according to Claim 1, characterised in that the diameter of the reaction vessel (6') is substantially greater in its upper part (6a) in the region of the level sensor (8) than in its lower part (6b).

## Revendications

1. Appareil pour la production d'un mélange gazeux par le procédé de saturation, comprenant un réservoir pour le liquide et un tube plongeur pour l'injection d'un gaz véhicule dans le liquide, dans lequel le réservoir (2) est relié par un conduit de liquide (5) à un récipient de réaction séparé (6) dans lequel on amène le gaz véhicule par le tube plongeur (16), caractérisé en ce que le volume du récipient de réaction (6) est de beaucoup inférieur au volume du réservoir (2), le récipient de réaction (6) est équipé d'un indicateur de niveau (8) sans contact, qui commande un dispositif de dosage des quantités (10) dans le conduit de liquide (5) menant au récipient de réaction (6), et le récipient de réaction (6) est placé dans un bloc métallique (7) relié à un dispositif de régulation de la température (11).

2. Appareil selon la revendication 1, caractérisé en ce que le récipient de réaction (6) consiste en quartz.

3. Appareil selon la revendication 1, caractérisé en ce que le conduit de liquide (5) provenant du dispositif de dosage des quantités (10) passe par un ou plusieurs orifices (12) du bloc métallique (7) avant d'atteindre le tube plongeur (16).

4. Appareil selon la revendication 1, caractérisé en ce que le rapport hauteur/diamètre du récipient de réaction (6) se situe approximativement dans l'intervalle de 4 : 1 à 8 : 1.

5. Appareil selon la revendication 1, caractérisé en ce que le dispositif de dosage des quantités consiste en un régulateur à deux positions avec une soupape (10) manoeuvrable entre une position fermée et une position ouverte dans le conduit de liquide (5).

6. Appareil selon la revendication 1, caractérisé en ce que le récipient de réaction (6'), dans sa partie supérieure (6a), dans la région de l'indicateur de niveau (8), a un diamètre très supérieur à celui de sa partie inférieure (6b).

FIG.1

FIG.2